# EUROPEAN PATENT SPECIFICATION

(11) **EP 3 232 262 B1**
(45) Date of publication and mention of the grant of the patent: **30.10.2019**
(21) Application number: 15793662.6
(22) Date of filing: 22.05.2015
(51) Int. Cl.: G02F 1/1362, G02F 1/1335, H01L 27/12

(54) **ARRAY SUBSTRATE, MANUFACTURING METHOD THEREFOR, AND TOTALLY REFLECTIVE LIQUID CRYSTAL DISPLAY**
ARRAYSUBSTRAT UND ZUGEHÖRIGES HERSTELLUNGSVERFAHREN SOWIE VOLLKOMMEN REFLEKTIVE FLÜSSIGKRISTALLANZEIGE
SUBSTRAT DE RÉSEAU, SON PROCÉDÉ DE FABRICATION, ET DISPOSITIF D'AFFICHAGE À CRISTAUX LIQUIDES ENTIÈREMENT RÉFLÉCHISSANT

(30) Priority: 10.12.2014 CN 201410752941
(43) Date of publication of application: 18.10.2017
(73) Proprietor: BOE Technology Group Co., Ltd., Beijing 100015 (CN)
(72) Inventor: LV, Zhijun, Beijing 100176 (CN); LI, Tailiang, Beijing 100176 (CN); GAO, Tao, Beijing 100176 (CN); NING, Ce, Beijing 100176 (CN); SUN, Shuang, Beijing 100176 (CN)
(74) Representative: Potter Clarkson
(86) International application number: PCT/CN2015/079580
(87) International publication number: WO 2016/090853

(56) References cited:
- CN-A- 1 987 627
- CN-A- 102 468 340
- CN-A- 102 629 054
- CN-A- 104 375 348
- US-A1- 2005 140 862
- US-A1- 2012 119 211
- US-A1- 2014 091 390
- US-B1- 6 188 456

## Description

### BACKGROUND

### Technical Field

Embodiments of the present invention generally relate to the field of display technology, and particularly, to an array substrate and a method for manufacturing the same, and a totally reflective type liquid crystal display comprising the array substrate.

### Description of the Related Art

US2005140862 A1 discloses a liquid crystal display device with a TFT array substrate comprising a reflective layer, wherein suitable materials for the gate and source/drain layers include molybdenum. US 6188456 B1 discloses a liquid crystal display that uses a low-temperature poly silicon TFT, and has a wide viewing angle. US 2012/119211 A1 discloses a thin film transistor including a gate electrode on a substrate.

Since 1990s, it is attempted to achieve display by means of a method without use of back light, and to seek a novel thin-film transistor (TFT) liquid crystal display (LCD) with thin, weight-light construction and low power consumption. It is called as a reflective type thin-film transistor liquid crystal display (Reflective type TFT-LCD) since such method displays image by means of reflecting environmental light.

Reflective type liquid crystal display not only meets power-saving and energy conservation display demands by utilization and modulation of environmental light, but also maintains advantages and characteristics of conventional liquid crystal display, which has become a major trend in the development of current liquid crystal display. However, polarizer must be used in Twisted Nematic (TN) LCD and Super Twisted Nematic (STN) LCD, so it has a murky grey display ground color, low contrast and poor display quality.

For a common TFT-LCD, introduction of a resin layer, as a flat layer, improves overall power consumption of the device and increases aperture ratio and light transmittance, etc. For a totally reflective mode LCD, flatness of the resin layer plays an important role on reflectivity of the reflective type LCD. The reflectivity of the reflective device will vary greatly, even if it is the same reflective metal with same reflection structure to be deposited on the resin layers with different flatness.

### SUMMARY

The present disclosure has been made to overcome or alleviate at least one aspect of the above mentioned and other disadvantages and defects existing in the prior art.

According to an aspect of the present disclosure, there is provided an array substrate as defined in appended claim 1, comprising a substrate, a plurality of pixel regions on the substrate, and a thin-film transistor formed in each of the pixel regions, each of the pixel regions comprising a pixel electrode region, wherein, the thin-film transistor comprises a gate layer and a source/drain layer formed laminatedly on the substrate; the array substrate further comprises a flat layer and a reflective metal layer formed in sequence on the substrate and covering at least the pixel electrode region and the thin-film transistor; the reflective metal layer is electrically connected to a drain of the thin-film transistor; and the gate layer and the source/drain layer both are formed of a molybdenum layer with a thickness of 220 nm (2200 Å).

In the above mentioned array substrate, a portion of the reflective metal layer covering the pixel electrode region may be substantially flat.

In the above mentioned array substrate, the reflective metal layer may be formed of one of Al, Ag and AlNd.

In the above mentioned array substrate, the flat layer may comprise a resin layer.

The above mentioned array substrate may further comprise a surrounding lead wire region, wherein, the reflective metal layer may be further formed on the surrounding lead wire region; and a portion of the reflective metal layer located on the surrounding lead wire region is covered with an indium tin oxide layer.

According to another aspect of the present disclosure, there is provided a totally reflective type liquid crystal display comprising the above mentioned array substrate.

According to yet another aspect of the present disclosure, there is provided a method for manufacturing an array substrate as defined in appended claim 6, the method comprising: providing a substrate comprising a plurality of pixel regions which is to form a plurality of pixels, each of the pixel regions comprising a pixel electrode region which is to form a pixel electrode; forming a thin-film transistor in the pixel region, wherein the thin-film transistor comprises a gate layer and a source/drain layer formed laminatedly on the substrate, and, the gate layer and the source/drain layer are both formed of a single metal layer; and forming a flat layer and a reflective metal layer, which cover at least the pixel electrode region and the thin-film transistor, in sequence on the substrate, wherein the reflective metal layer is configured to be electrically connected to a drain of the thin-film transistor, wherein the gate layer and the source/drain layer both are formed of a molybdenum layer with a thickness of 220 nm (2200 Å).

In the above mentioned method, a portion of the reflective metal layer covering the pixel electrode region may be substantially flat.

In the above mentioned method, the reflective metal layer may be formed of one of Al, Ag and AlNd.

In the above mentioned method, the flat layer may comprise a resin layer.

The substrate used in the above mentioned method may further comprise a surrounding lead wire region, wherein the reflective metal layer is further formed on the surrounding lead wire region; the method may further comprise: forming an indium tin oxide layer, which covers a portion of the reflective metal layer located on the surrounding lead wire region, on the substrate.

Other objectives and advantages of the present disclosure will become apparent from the following detailed description, taken in conjunction with the accompanying drawings, which may be helpful to achieve a complete understanding of the present disclosure.

### BRIEF DESCRIPTION OF THE DRAWINGS

These features and advantages of the present disclosure will become apparent with reference to the accompanying drawings, and the drawings are exemplary and are not intended to limit the present disclosure, in which:
Fig. 1 is a schematic sectional view of an array substrate for a totally reflective type liquid crystal display according to an embodiment of the present invention; and
Fig. 2 is a flowchart of a method for manufacturing an array substrate according to an embodiment of the present invention.

### DETAILED DESCRIPTION OF THE EMBODIMENTS

A further detailed description of the present disclosure has been provided in conjunction with these specific embodiments, as well as the accompanying drawings, in order to clearly understand these objectives, technical solutions, and advantages of the present disclosure.

In addition, in the following detailed description, for explanations and interpretations, lots of specific details are illustrated in order to provide a full understanding on embodiments of the present invention. However, obviously, one or more embodiment without these specific details may also be implemented. In other cases, known structures and devices are reflected in graphical representations in order to simplify the drawings.

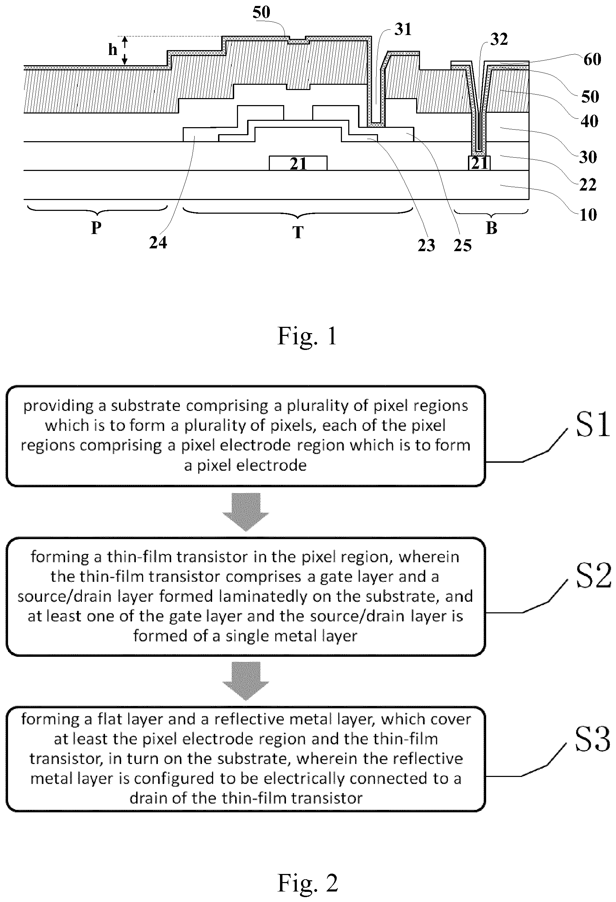

Fig. 1 shows structure of an array substrate according to an exemplary embodiment of the present invention. As shown in Fig. 1, the array substrate mainly comprises a substrate 10; a plurality of pixel regions, defined by data lines and gate lines (no shown) intersecting with each other, on the substrate; and a thin-film transistor T formed in each of the pixel regions, each of the pixel regions comprising a pixel electrode region P. As can be understood, a region B surrounding such array substrate may act as a lead wire bonding region.

The thin-film transistor T comprises a gate layer 21, a gate insulation layer 22, an active layer 23, and a source/drain layer formed laminatedly on the substrate 10 in sequence. The source/drain layer is formed therein with a source 24 and a drain 25 of the thin-film transistor T.

The array substrate further comprises a passivation layer 30, a flat layer 40 and a reflective metal layer 50 formed in sequence on the substrate 10 and covering at least the pixel electrode region P and the thin-film transistor T. In one example, the flat layer 40 may be formed of resin. The reflective metal layer 50 is electrically connected to the drain 25 of the thin-film transistor T, for example, through a via hole 31 formed in the passivation layer 30 and the flat layer 40, and thus, it is also used as a pixel electrode.

The following Table 1 shows measuring data for reflectivity of some metals.

It can be seen from Table 1 that, Al, Ag and AlNd have a relatively high reflectivity, and are capable of achieving an approximate specular reflection, and accordingly, they are preferably used as the reflective metal layer in the TFT array substrate. On the other hand, Ag has an extremely high reflectivity, but it encounters expensive cost and relatively complicated manufacturing process, as a result, it is not suitable for mass production process. AlNd has a slightly lower reflectivity than Ag, but it is low-cost, thereby AlNd may substitute for Ag to implement mass production due to simple manufacturing process. In one example of the present disclosure, AlNd is chosen to form the reflective metal layer.

**Table 1**

| The Metal Layer | Thickness | 1 | 2 | 3 | 4 | 5 | 6 | 7 | 8 | 9 | Average Reflectivity (%) | Homo geneity | 3σ |
|---|---|---|---|---|---|---|---|---|---|---|---|---|---|
| Ti | 2000Å | 54.55 | 48.33 | 50.47 | 44.71 | 41.45 | 42.9 | 42.65 | 41.57 | 42.39 | 45.45 | 13.6% | 13.89 |
| | | 54.19 | 49.24 | 53.84 | 48.77 | 41.99 | 42.73 | 42.64 | 42.18 | 50.56 | 47.35 | 12.7% | 15.14 |
| Ti/ITO | 2000Å/120Å | 39.95 | 38.03 | 42.32 | 37.9 | 32.87 | 33.56 | 33.85 | 33.93 | 39.17 | 36.84 | 12.6% | 10.15 |
| | | 42.31 | 37.97 | 41.29 | 35.31 | 31.7 | 32.87 | 34.49 | 33.1 | 39.38 | 36.49 | 14.3% | 11.64 |
| Al | 3000Å | 97.47 | 97.44 | 97.46 | 97.49 | 97.49 | 97.54 | 97.45 | 97.41 | 97.48 | 97.47 | 0.1% | 0.11 |
| | | 97.53 | 97.51 | 97.48 | 97.51 | 97.46 | 97.49 | 97.49 | 97.46 | 97.59 | 97.50 | 0.1% | 0.12 |
| Ag | 1000Å | 98.71 | 98.97 | 98.70 | 98.75 | 98.90 | 98.88 | 98.25 | 98.5 | 98.58 | 98.69 | 0.4% | 0.67 |
| | | 99.89 | 99.71 | 99.43 | 100 | 99.72 | 99.5 | 99.6 | 99.48 | 99.5 | 99.65 | 0.3% | 0.59 |
| AINd | 3000Å | 96.11 | 96.27 | 96.16 | 96.1 | 96.05 | 96.14 | 96.25 | 96.17 | 94.35 | 95.96 | 1.0% | 1.82 |
| | | 96.32 | 96.37 | 96.36 | 96.26 | 96.25 | 96.28 | 96.34 | 96.29 | 96.34 | 96.31 | 0.1% | 0.13 |

As shown in Fig. 1, in the region of the pixel region where the thin-film transistor T is formed, due to formation and lamination of these layers of the thin-film transistor T, an altitude difference or difference in height h exists between the thin-film transistor T formation region and the pixel electrode region P, in the finally formed array substrate. As described above, for the totally reflective mode LCD, flatness of the flat layer plays an important role on reflectivity of the reflective type LCD. Most of the flat layers, e.g., resin layer, however, follow the shape of the bottom layer to spread out and are sensitive to fluctuation of the bottom layer. A flat layer with a great thickness (usually greater than 1um) may reduce the altitude difference to some extent, however, in the reflective mode, the reflective metal greatly relies on the whole flatness. The reflectivity of the reflective device will vary greatly, even if it is the same reflective metal with same reflection structure to be deposited on the resin layers with different flatness.

Conventionally, the gate layer and the source/drain layer of the thin-film transistor both adopt a multilayer or composite-layer metal structure having a relatively great thickness, while none of the gate layer and the source/drain layer are formed within the pixel electrode region, as a result, there exists a large altitude difference or difference in height h between the thin-film transistor formation region and the pixel electrode region, the deposited reflective metal layer has a poor whole flatness, especially within the pixel region, thereby resulting in a lower reflectivity of the finally patterned reflective metal layer.

The inventors have found that, by reducing the altitude, especially the above mentioned altitude difference or difference in height h within the pixel region, the flat layer may have a relatively well whole flatness, so that the reflective metal layer formed (e.g., deposited) on the flat layer has an improved reflectivity, and reflects the environmental light in a manner of more approximate specular reflection.

According to the present invention, the gate layer and the source/drain layer of the thin-film transistor T both are formed of a single metal layer, which reduces the altitude difference or difference in height h between the thin-film transistor and the pixel electrode region, and improves the whole flatness of the finally formed reflective metal layer within the pixel region, thus, it improves reflectivity of the reflective metal layer.

The following Table 2 shows reflectivity of the AlNd layer measured under different conditions, in which Columns A, B and C denote reflectivity of the patterned reflective metal layer made of AINd when the thin-film transistors constructed of electrode structures made of different materials are formed within the pixel region, and Column D denotes reflectivity of the AlNd layer which is directly formed on a completely flat surface.

**Table 2**

| Test Number | A: Mo 2200 Å (240°C) | B: Mo/AlNd/Mo 200/3000/1000 Å | C: Mo 2200 Å (180°C) | D: AINd Layer |
|---|---|---|---|---|
| 1 | 80.897 | 63.112 | 80.856 | 100.000 |
| 2 | 81.107 | 64.426 | 80.871 | 96.912 |
| 3 | 80.840 | 93.290 | 80.986 | 96.525 |
| 4 | 81.432 | 64.558 | 87.751 | 96.521 |
| 5 | 81.030 | 65.726 | 81.889 | 96.477 |
| 6 | 81.099 | 65.341 | 81.154 | 96.468 |
| 7 | 80.935 | 64.380 | 81.024 | 96.478 |
| 8 | 81.496 | 65.293 | 81.081 | 96.522 |
| 9 | 82.051 | 64.403 | 80.683 | 96.481 |
| Average Reflectivity of AlNd Layer | 81.210 | 64.503 | 81.144 | 96.485 |

According to the present invention, as shown in Table 2, the gate layer and the source/drain layer of the thin-film transistor T are both formed of molybdenum (Mo) layer with a thickness of 2200 angstrom (Å). Compared to the conventional thin-film transistor comprising the gate layer and the source/drain layer formed of Mo/AlNd/Mo composite structure with a thickness of 200/3000/1000 Å (that is, a Mo layer, an AlNd layer and A Mo layer with thickness of 1000Å, 3000Å and 200 Å respectively are laminated from bottom to top in sequence), it has a reduced thickness of, only (200+3000+1000) Å -2200 Å = 0.2um. Obviously, this reduction of the thickness reduces the above mentioned altitude difference or difference in height within the pixel region, which causes an average reflectivity of the AlNd layer, used as the reflective metal layer, to be increased at approximately 26%(=(81.210-64.503)/64.503).

In addition, since the gate layer and the source/drain layer of the thin-film transistor T of the present disclosure are both formed of molybdenum (Mo) with a thickness of 2200 angstrom (Å), the average reflectivity (81.210% or 81.144%) of the AlNd layer, used as the reflective metal layer, gets closer to the average reflectivity (96.485%) of the AlNd layer which is directly formed on a completely flat surface, than the average reflectivity (64.503%) of the conventional composite electrode structure, accordingly, it reflects the environmental light in a manner of more approximately specular reflection.

In addition, it can be seen from Table 2 that, in the same reflective mode, reflectivity of the same reflective metal can vary with some factors such as deposition conditions. Reflectivity of the same metal that has been deposited and patterned under different temperatures (Column A: 240°C, Column C: 180°C) changes little, for example, single layer of Mo electrode in Column A and Column C. The metal that has been deposited but not patterned has the highest reflectivity. In the array substrate, the portion of the reflective metal layer forming in the surrounding region B enables a pure specular reflection of high reflectivity since the surrounding region B is not patterned and still remains in a flat structure; in contrast, the pixel region is formed with a patterned structure and thus there is an altitude difference or difference in height, accordingly, the specular reflection is incomplete and the reflectivity reduces. Compared to the conventional thin-film transistor comprising the gate layer and the source/drain layer of composite electrode structure, in the present disclosure, at least one or all of the gate layer and the source/drain layer of the thin-film transistor are formed of a single metal layer, which reduces the above mentioned altitude difference or difference in height within the pixel region, thus, it obviously increases reflectivity of the reflective metal layer.

It can be understood that, the inventive Mo layer having a thickness of 2200Å is shown for comparison in these examples of Table 2; other metal layers having different thickness may be adopted, depending on factors including electrical conductivity, etching rate of metal, etc. which, however, do not fall within the scope of the present invention.

During the manufacturing of the array substrate, the etchings applied on the passivation layer and/or the gate insulation layer having the thickness of about 5000Å-7000Å are inevitably applied on the gate layer or the source/drain layer underneath. It has been proved in practice that, in order to ensure that the non-metal layer (the passivation layer and/or the gate insulation layer) is etched completely without any residue, over-etching time by 15%-30% is needed generally. The inventors have found that, in conventional reflective type liquid crystal display, due to presence of this over-etching as well as differences in factors such as etching rate for metal and non-uniform metal deposition, etc., for Mo/AlNd/Mo and other "composite" electrode structures, metal Mo in the top layer may be partially over-etched, further, metal AINd in the middle will not be protected well from being corroded in case that developer solution reacts strongly with the AlNd. However, in the present disclosure, at least one or all of the gate layer and the source/drain layer of the thin-film transistor is formed of a single metal layer, as a result, it avoids signal transmission from interruption, which is caused by corrosion of AlNd due to over-etching.

The gate layer and the source/drain layer of the thin-film transistor are both formed of molybdenum and have the same thickness.

Since no patterned structure is formed within the pixel electrode region, portions of the passivation layer and the flat layer within the pixel electrode region are substantially flat. However, in the embodiments of the present invention, a portion of the reflective metal layer covering the pixel electrode region is substantially flat. Moreover, the increased reflectivity results in that the environmental light may be reflected in a manner of approximate specular reflection, which increases light use efficiency, brightness and contrast ratio of the liquid crystal display.

As shown in Fig. 1, in one example, the reflective metal layer 50 may further be formed within the surrounding lead wire region B. The portion of the reflective metal layer 50 forming in the surrounding lead wire region B and the portion of the reflective metal layer 50 forming in the pixel region (P+T regions) are separated from each other, and electrically connected to the gate layer 21 through a via hole 32 in the passivation layer 30 and the gate insulation layer 22. The portion of the reflective metal layer 50 forming in the surrounding lead wire region may further be covered with a tin indium oxide (ITO) layer 60, as a result, the gate layer 21 is leaded out by means of the reflective metal layer 50 and the ITO layer 60. Of course, the source and drain of the thin-film transistor may be leaded out by means of the portion of the reflective metal layer forming in the surrounding lead wire region, although not shown.

The array substrate according to the present disclosure may be used in a totally reflective type liquid crystal display, to improve light use efficiency, brightness and contrast ratio of the liquid crystal display.

A method for manufacturing the above mentioned array substrate according to the present disclosure will be described hereafter. Fig. 2 shows a flowchart of a method for manufacturing an array substrate according to an embodiment of the present invention. First of all, in step S1, a substrate, e.g., glass substrate, is provided. As shown in Fig. 1, the substrate comprises a plurality of regions including a plurality of pixel regions P which is generally located in the middle and is to form a plurality of pixels, and a surrounding lead wire bonding region. Each of the pixel regions comprises a pixel electrode region which is to form a pixel electrode and a region which is to form a thin-film transistor.

In step S2, a thin-film transistor is formed in each pixel region, by laminating and patterning a gate layer 21, a gate insulation layer 22, an active layer 23, and a source/drain layer on the substrate in sequence. The source/drain layer is formed therein with a source 24 and a drain 25 of the thin-film transistor T. According to the present invention, the gate layer and the source/drain layer are both formed of a single metal layer, which reduces the altitude difference or difference in height between a region where the thin-film transistor is located and the pixel electrode region. According to the invention, the gate layer and the source/drain layer both are formed of a single metal layer of molybdenum. The gate layer and the source/drain layer are formed of one and the same metal, which simplifies manufacturing process. They have the same thickness, i.e. both are formed of molybdenum layer with a thickness of 2200 Å.

In step S3, a flat layer 40 and a reflective metal layer 50, which cover at least the pixel electrode region P and the thin-film transistor T, are formed on the substrate in sequence, wherein the reflective metal layer 50 is electrically connected to a drain of the thin-film transistor. In one example, prior to formation of the flat layer, a passivation layer 30, which covers at least the pixel electrode region P and the thin-film transistor T, is formed on the substrate 10. In one example, the reflective metal layer 50 is electrically connected to a drain 25 of the thin-film transistor T, e.g., through a via hole 31 formed in the passivation layer 30 and the flat layer 40, and thus, it is also used as a pixel electrode. In one example, the flat layer 40 may be formed of resin. In one example, as shown in Fig. 1, the portion of the reflective metal layer 50 covering the pixel electrode region P may be substantially flat, and this portion may be formed of one of Al, Ag and AlNd. In the present disclosure, process for forming each layer may not be limited, e.g., it comprises semiconductor processes such as deposition, sputtering, etc.

## Claims

1. An array substrate, comprising a substrate (10), a plurality of pixel regions on the substrate, and a thin-film transistor (T) formed in each of the pixel regions, each of the pixel regions comprising a pixel electrode region (P), wherein,
the thin-film transistor comprises a gate layer (21) and a source/drain layer (24, 25) formed laminatedly on the substrate;
the array substrate further comprises a flat layer (40) and a reflective metal layer (50) formed in sequence on the substrate and covering at least the pixel electrode region and the thin-film transistor;
the reflective metal layer is electrically connected to a drain (25) of the thin-film transistor; and
the gate layer (21) and the source/drain layer (24, 25) both are formed of a molybdenum layer with a thickness of substantially 220 nm (2200 Å).

2. The array substrate of claim 1, wherein a portion of the reflective metal layer (50) covering the pixel electrode region (P) is substantially flat, and the reflective metal layer is formed of one of Al, Ag and AlNd.

3. The array substrate of any one of claims 1-2, wherein the flat layer (40) comprises a resin layer.

4. The array substrate of any one of claims 1-3, further comprising a surrounding lead wire region, wherein
the reflective metal layer (50) is further formed on the surrounding lead wire region; and a portion of the reflective metal layer located on the surrounding lead wire region is covered with an indium tin oxide layer.

5. A totally reflective type liquid crystal display, comprising an array substrate of any one of claims 1-4.

6. A method for manufacturing an array substrate, comprising:
providing (S1) a substrate comprising a plurality of pixel regions which is to form a plurality of pixels, each of the pixel regions comprising a pixel electrode region which is to form a pixel electrode;
forming (S2) a thin-film transistor in the pixel region, wherein the thin-film transistor comprises a gate layer and a source/drain layer formed laminatedly on the substrate, and the gate layer and the source/drain layer both are formed of a molybdenum layer with a thickness of substantially 220 nm (2200 Å); and
forming (S3) a flat layer and a reflective metal layer, which cover at least the pixel electrode region and the thin-film transistor, in sequence on the substrate, wherein the reflective metal layer is configured to be electrically connected to a drain of the thin-film transistor.

7. The method of claim 6, wherein a portion of the reflective metal layer covering the pixel electrode region is substantially flat.

8. The method of claim 7, wherein the reflective metal layer is formed of one of Al, Ag and AlNd.

9. The method of any one of claims 7-8, wherein the flat layer comprises a resin layer.

10. The method of any one of claims 7-9, wherein the substrate further comprises a surrounding lead wire region, wherein the reflective metal layer is further formed on the surrounding lead wire region; the method further comprises:
forming an indium tin oxide layer, which covers a portion of the reflective metal layer located on the surrounding lead wire region, on the substrate.

## Patentansprüche

1. Arraysubstrat, umfassend ein Substrat (10), mehrere Pixelbereiche auf dem Substrat und einen Dünnfilmtransistor (T), der in jedem der Pixelbereiche ausgebildet ist, wobei jeder der Pixelbereiche einen Pixelelektrodenbereich (P) umfasst, wobei der Dünnfilmtransistor eine Gateschicht (21) und eine Quell-/Ableit-Schicht (24, 25) umfasst, die laminiert auf dem Substrat ausgebildet sind;
das Arraysubstrat ferner eine flache Schicht (40) und eine reflektierende Metallschicht (50) umfasst, die hintereinander auf dem Substrat gebildet sind und mindestens den Pixelelektrodenbereich und den Dünnfilmtransistor bedecken;
die reflektierende Metallschicht elektrisch mit einem Ableiter (25) des Dünnfilmtransistors verbunden ist; und
die Gateschicht (21) und die Quell-/Ableit-Schicht (24, 25) beide aus einer Molybdänschicht mit einer Dicke von im Wesentlichen 220 nm (2200 Å) gebildet sind.

2. Arraysubstrat nach Anspruch 1, wobei ein Abschnitt der reflektierenden Metallschicht (50), der den Pixelelektrodenbereich (P) bedeckt, im Wesentlichen flach ist, und die reflektierende Metallschicht aus Al, Ag oder AINd gebildet ist.

3. Arraysubstrat nach einem der Ansprüche 1 bis 2, wobei die flache Schicht (40) eine Harzschicht umfasst.

4. Arraysubstrat nach einem der Ansprüche 1 bis 3, ferner umfassend einen umgebenden Leitungsdrahtbereich, wobei die reflektierende Metallschicht (50) ferner auf dem umgebenden Leitungsdrahtbereich ausgebildet ist; und
ein Abschnitt der reflektierenden Metallschicht, der sich auf dem umgebenden Leitungsdrahtbereich befindet, ist mit einer Indiumzinnoxidschicht bedeckt ist.

5. Totalreflektierende Flüssigkristallanzeige, umfassend ein Arraysubstrat nach einem der Ansprüche 1 bis 4.

6. Verfahren zum Herstellen eines Arraysubstrats, Folgendes umfassend:
das Bereitstellen (S1) eines Substrats, das mehrere Pixelbereiche umfasst, die mehrere Pixel bilden sollen, wobei jeder der Pixelbereiche einen Pixelelektrodenbereich umfasst, der eine Pixelelektrode bilden soll;
das Ausbilden (S2) eines Dünnfilmtransistors im Pixelbereich, wobei der Dünnfilmtransistor eine Gateschicht und eine Quell-/Ableit-Schicht umfasst, die laminiert auf dem Substrat ausgebildet sind, und wobei die Gateschicht und die Quell/Ableit-Schicht beide aus einer Molybdänschicht mit einer Dicke von im Wesentlichen 220 nm (2200 Å) gebildet sind; und
das Ausbilden (S3) einer flachen Schicht und einer reflektierenden Metallschicht, die mindestens den Pixelelektrodenbereich und den Dünnfilmtransistor in Folge auf dem Substrat bedecken, wobei die reflektierende Metallschicht konfiguriert ist, um elektrisch mit einem DrainAbleiter des Dünnfilmtransistors verbunden zu werden, wobei die reflektierende Metallschicht konfiguriert ist, um elektrisch mit einem Ableiter des Dünnfilmtransistors verbunden zu werden.

7. Verfahren nach Anspruch 6, wobei ein Abschnitt der reflektierenden Metallschicht, der den Pixelelektrodenbereich bedeckt, im Wesentlichen flach ist.

8. Verfahren nach Anspruch 7, wobei die reflektierende Metallschicht aus Al, Ag oder AlNd gebildet ist.

9. Verfahren nach einem der Ansprüche 7 bis 8, wobei die flache Schicht eine Harzschicht umfasst.

10. Verfahren nach einem der Ansprüche 7 bis 9, wobei das Substrat ferner einen umgebenden Leitungsdrahtbereich umfasst, wobei die reflektierende Metallschicht weiterhin auf dem umgebenden Leitungsdrahtbereich ausgebildet ist;
und wobei das Verfahren ferner Folgendes umfasst:
das Ausbilden einer Indiumzinnoxidschicht, die einen Abschnitt der reflektierenden Metallschicht bedeckt, die sich auf dem umgebenden Leitungsdrahtbereich auf dem Substrat befindet.

## Revendications

1. Substrat de réseau comprenant un substrat (10), une pluralité de régions de pixel sur le substrat et un transistor à couches minces (T) formé dans chacune des régions de pixel, chacune des régions de pixel comprenant une région d'électrode de pixel (P), dans lequel le transistor à couches minces comprend une couche de grille (21) et une couche de source/drain (24, 25) formée de manière stratifiée sur le substrat ;
le substrat de réseau comprend en outre une couche plate (40) et une couche métallique réfléchissante (50) formées en séquence sur le substrat et recouvrant au moins la région d'électrode de pixel et le transistor à couches minces ;
la couche métallique réfléchissante est connectée électriquement à un drain (25) du transistor à couches minces ; et
la couche de grille (21) et la couche de source/drain (24, 25) sont toutes formées d'une couche de molybdène d'une épaisseur sensiblement de 220 nm (2 200 Å).

2. Substrat de réseau selon la revendication 1, dans lequel une partie de la couche métallique réfléchissante (50) recouvrant la région d'électrode de pixel (P) est sensiblement plate, et la couche métallique réfléchissante est formée de l'Al, de l'Ag ou de l'AlNd.

3. Substrat de réseau selon l'une quelconque des revendications 1 à 2, dans lequel la couche plate (40) comprend une couche de résine.

4. Substrat de réseau selon l'une quelconque des revendications 1 à 3, comprenant en outre une région environnante de fil conducteur, la couche métallique réfléchissante (50) étant en outre formée sur la région environnante de fil conducteur ; et
une partie de la couche métallique réfléchissante se trouvant sur la région environnante de fil conducteur étant recouverte d'une couche d'oxyde d'indium et d'étain.

5. Écran d'affichage à cristaux liquides de type totalement réfléchissant, comprenant un substrat de réseau selon l'une quelconque des revendications 1 à 4.

6. Procédé de fabrication d'un substrat de réseau, consistant à :
fournir (S1) un substrat comprenant une pluralité de régions de pixel destinées à former une pluralité de pixels, chacune des régions de pixel comprenant une région d'électrode de pixel destinée à former une électrode de pixel ;
former (S2) un transistor à couches minces dans la région de pixel, le transistor à couches minces comprenant une couche de grille et une couche de source/drain formée de manière stratifiée sur le substrat, la couche de grille et la couche de source/drain étant toutes formées d'une couche de molybdène d'une épaisseur sensiblement de 220 nm (2 200 Å); et
former (S3) une couche plate et une couche métallique réfléchissante recouvrant au moins la région d'électrode de pixel et le transistor à couches minces, en séquence sur le substrat, la couche métallique réfléchissante étant configurée pour être connectée électriquement à un drain du transistor à couches minces.

7. Procédé selon la revendication 6, dans lequel une partie de la couche métallique réfléchissante recouvrant la région d'électrode de pixel est sensiblement plate.

8. Procédé selon la revendication 7, dans lequel la couche métallique réfléchissante est formée de l'Al, de l'Ag ou de l'AlNd.

9. Procédé selon l'une quelconque des revendications 7 à 8, dans lequel la couche plate comprend une couche de résine.

10. Procédé selon l'une quelconque des revendications 7 à 9, dans lequel le substrat comprend en outre une région environnante de fil conducteur, la couche métallique réfléchissante étant en outre formée sur la région environnante de fil conducteur ;
le procédé consistant en outre à :
former une couche d'oxyde d'indium et d'étain, qui recouvre une partie de la couche métallique réfléchissante se trouvant sur la région environnante de fil conducteur, sur le substrat.
